# EUROPEAN PATENT SPECIFICATION

(11) **EP 2 376 928 B1**
(45) Date of publication and mention of the grant of the patent: **23.08.2017**
(21) Application number: 09832984.0
(22) Date of filing: 03.12.2009
(51) Int. Cl.: G01R 31/00, H01H 85/00, H02J 13/00, B66B 1/30

(54) **ARRANGEMENT FOR PROTECTING A FUSE FOR A POWER SUPPLY CIRCUIT**
ANORDNUNG ZUM SCHÜTZEN EINER SICHERUNG FÜR EINEN STROMSCHALTKREIS
CONFIGURATION DE PROTECTION D'UN FUSIBLE POUR UN CIRCUIT D'ALIMENTATION

(30) Priority: 19.12.2008 FI 20080667
(43) Date of publication of application: 19.10.2011
(73) Proprietor: Kone Corporation, 00330 Helsinki (FI)
(72) Inventor: PUTKINEN, Esa, 00330 Helsinki (FI); LEHTINEN, Hannu, 00330 Helsinki (FI)
(74) Representative: Glück Kritzenberger Patentanwälte PartGmbB
(86) International application number: PCT/FI2009/000101
(87) International publication number: WO 2010/070188

(56) References cited:
- EP-A2- 2 031 948
- WO-A1-2008/078377
- WO-A1-2008/097982
- DE-A1- 4 110 335
- JP-A- 11 356 036
- JP-A- H11 356 036
- JP-A- 2002 279 880
- JP-A- 2007 043 860
- US-A- 3 638 157
- US-A- 5 867 809

## Description

The present invention relates to an arrangement as defined in the preamble of claim 1, to a transportation system as defined in the preamble of claim 9, to an elevator system as defined in the preamble of claim 12. The instantaneous electric power flowing in a power supply system varies. For instance, the power taken from the electric network of a building and likewise the power possibly returned into the electric network varies with time. However, an electricity supply connection is usually designed according to the highest power requirement, and therefore the variation in power also affects the costs of power supply to the building. Many other fuses in different power supply systems are also designed according to the highest power to be handled.

For example, in an elevator system power is supplied from an electricity network to the elevator motor in order to move the elevator car. The supply of power to the motor is generally implemented using a frequency converter. When the elevator car is braked by the motor, power is also returned from the motor to the frequency converter, from which it is often transferred further back into the electricity network. The instantaneous power supplied to the motor or returning from the motor is generally greater during acceleration and braking of an elevator system than during constant-speed operation.

Publication US4545464 proposes an elevator system in which braking power returning from the motor is fed into the electricity supply of the elevator system.

To solve the problems referred to above as well as those discussed in the below description of the invention, a novel method for handling temporally varying power in a power supply system is disclosed as an invention.

The JP 2007 043860 A discloses an arrangement according to the preamble of claim 1. The JP 11356036 A discloses an arrangement to detect the timing of replacement of a smoothing capacitor. On this behalf a life prediction circuit is provided which predicts life time based on ambient temperature, ripple current value life characteristic data and passed and expected life time.

The arrangement of the invention is characterized by what is disclosed in claim 1. Preferred embodiments of the invention are characterized by what is disclosed in the dependent claims. Inventive embodiments are also presented in the description part of the present application. The inventive content may also consist of several separate inventions, especially if the invention is considered in the light of explicit or implicit subtasks or with respect to advantages or sets of advantages achieved. In this case, some of the attributes contained in the claims below may be superfluous from the point of view of separate inventive concepts.

In the invention, "electric quantity constituting a load on a fuse" refers e.g. to a voltage across the poles of the fuse, to a current flowing through the fuse, and also to the frequency and/or rate of change of the current and/or voltage. The electric quantity can be defined repeatedly e.g. by determining the instantaneous value of the quantity, by calculating the mean value or root-mean-square value of the quantity between the instants of determination, or by interpolating the value of the electric quantity.

"Power supply circuit" in the invention refers to a circuit consisting of electric devices, fuses and wirings through which electricity is supplied to the system. The advantages achieved by the invention include at least one of the following:

The arrangement of the invention comprises determination of an electric quantity constituting a load on a fuse, which electric quantity constituting a load on the fuse is determined repeatedly while the fuse is exposed to the load, said arrangement comprising estimation of instantaneous load capacity of the fuse, which estimation of instantaneous load capacity is performed using limitation criteria set for the load capacity of the fuse. A first limitation criterion indicates the longest possible operating time of the fuse under a given loading condition. For the limitation criterion, a representation with respect to the electric quantity constituting a load on the fuse is prepared, and a limitation criterion corresponding to the defined electric quantity constituting a load on the fuse is derived repeatedly from the said diagram while the fuse is exposed to the load. The estimate of instantaneous load capacity of the fuse is determined on the basis of both the limitation criterion defined substantially at the instant of estimation and the limitation criteria defined before this.

The limitation criterion may be represented e.g. as a function including the said electric quantity as a variable; on the other hand, the limitation criterion may be represented e.g. in tabular or graphic form with respect to the said electric quantity. As a limitation criterion, it is possible to use e.g. the longest total time allowed for overloading of the fuse, or the recovery time required as a whole for recovery from overloading. The limitation criterion may be represented linearly or non-linearly with respect to the electric quantity constituting a load on the fuse. The limitation criterion may be defined repeatedly; likewise, the instantaneous load capacity of the fuse may be estimated from a repeatedly defined limitation criterion, in which case the loading history of the fuse is also taken into account in the estimation of instantaneous load capacity of the fuse. Thus, as the estimation of instantaneous load capacity of the fuse becomes more accurate, the protection of the fuse against overloading is also improved. Due to the improved overload protection, the fuse can momentarily be subjected to a load exceeding the nominal load. This is useful especially in systems where the fuse is exposed to a temporally varying load, because in this case the fuse need not necessarily be rated for the highest instantaneous load, so it is possible to use fuses of a lower power handling capacity. The fuses to be protected may include e.g. so-called slow fuses, or e.g. different power semiconductors, resistors, inductors, capacitors and transformers. In the case of a slow fuse, heating-up is reduced by increasing the heating-up time constant of the fuse, e.g. by adding sand or some other heat-retarding material around the fuse wire.

According to the invention, the estimation of instantaneous load capacity is performed using additionally a second limitation criterion set for the load capacity of the fuse, this second limitation criterion indicating the recovery time of the fuse under a given loading condition. The recovery of the fuse can thus be determined, and when the fuse is recovering, its momentary overload capacity increases.

In an embodiment of the invention, the arrangement comprises a representation of the time to failure of the fuse, wherein the time to failure is represented with respect to an electric quantity constituting a load on the fuse. "Time to failure" refers to the total time that the fuse will typically tolerate a given loading, so that the loading would finally lead to failure of the fuse. The electric quantity constituting a load on the fuse and the corresponding time to failure are defined repeatedly, and the estimate of instantaneous load capacity of the fuse is determined on the basis of both the time to failure defined substantially at the moment of estimation and the times to failure defined previously. The protection of the fuse against overloading is thus improved.

According to the invention, the load capacity of the power supply circuit fuse to be protected can be determined without separate measurement of the temperature of the fuse. Thus, as the number of temperature sensors is reduced, the overall system is simplified and the reliability of the system improved.

Different systems subject to varying loads include e.g. transportation systems, such as a passenger or freight elevator system, escalator system, passenger conveyor system, roller elevator system, crane system, vehicle system or a conveyor system for conveying goods and/or raw materials. The aforesaid elevator system may be a system with or without machine room. The elevator system may also be a counterweighted or counterweightless system.

The transportation system of the invention comprises an arrangement for protecting a fuse in the power supply to the transportation system, said arrangement comprising determination of the current flowing through the fuse, which fuse current is determined repeatedly while the fuse is exposed to a load. The arrangement also comprises estimation of instantaneous load capacity of the fuse, which estimation of instantaneous load capacity is performed using a limitation criterion set for the load capacity of the fuse. This limitation criterion indicates the longest possible operating time of the fuse under a given loading condition. For the limitation criterion, a representation with respect to the fuse current is provided, and a limitation criterion corresponding to the defined fuse current is derived repeatedly from the said representation while the fuse is exposed to a load. The estimate of instantaneous load capacity of the fuse is thus determined on the basis of both the limitation criterion defined substantially at the instant of estimation and the limitation criteria defined before this. The fuse current is adapted to be limited to a given boundary current value, and this boundary current value is determined according to the estimated load capacity of the fuse. In an embodiment of the invention, power exceeding the limited current handling capacity of the fuse is adapted to be consumed in a resistor connected to the power supply circuit of the transportation system.

When the fuse in the power supply to the transportation system is thus protected by the method of the invention, a fuse rating below the required instantaneous maximum loading can be selected for the building. As the fuse rating has a substantial effect on the costs of power supply to the building, the invention thus makes it possible to achieve significant savings.

In an embodiment of the invention, the power supply circuit comprises a control function, and this power supply control function is adapted to limit the current flowing through a fuse in the power supply circuit to a given boundary current value, said boundary current value being determined according to an estimated instantaneous load capacity of the fuse. The boundary current value can be varied in accordance with the instantaneous estimate of the load capacity of the fuse. For example, the current flowing in the power supply circuit of a transportation system can thus be limited to the boundary current value allowed at a given instant of time, and the boundary value can be varied in response to load capacity and/or to a change in load capacity. This also allows the fuse to be subjected to an instantaneous load exceeding the nominal load.

In an embodiment of the invention, the estimation of load capacity of the fuse is implemented using a fuse recovery time corresponding to the value of the electric quantity constituting a load on the fuse. The reason for this is that, when the loading on the fuse is reduced to a level below a given boundary loading value, the fuse begins to recover. The fuse temperature starts falling at a rate determined by the thermal time constant, and the recovery takes place the faster the lower is the loading during recovery. Therefore, as the fuse is recovering / cooling down, the estimate of instantaneous load capacity of the fuse starts rising correspondingly, and thus the determination of fuse recovery time can be utilized to achieve a more accurate estimate of the instantaneous value of the load capacity of the fuse. According to the invention, the recovery time is so defined that it corresponds to the total time after which the fuse will be considered as having completely recovered from the strain preceding recovery if the electric quantity constituting a load on the fuse remains constant throughout the recovery period.

An elevator system according to the invention comprises one of the above-introduced arrangements for protecting a fuse in the power supply circuit of the elevator system.

According to one or more embodiments of the invention, data indicating the instantaneous load capacity of the power supply circuit fuse is arranged to be transmitted to an elevator maintenance center. The data indicating the instantaneous load capacity of the power supply circuit fuse can thus also be used e.g. for remote control and/or maintenance of the elevator.

In the following, the invention will be described in detail by referring to embodiment examples and the attached drawings, wherein
- Fig. 1a: is a representation of fuse failure time and fuse recovery time according to the invention
- Fig. 1b: represents the instantaneous load capacity of a fuse in an embodiment of the invention
- Fig. 2: is a block diagram representing estimation of fuse load capacity according to the invention
- Fig. 3: represents a power supply arrangement according to the invention for a transportation system
- Fig. 4: represents a second power supply arrangement according to the invention for a transportation system
- Fig. 5: represents an elevator system according to the invention
- Fig. 6: represents power flow in an elevator system according to the invention.

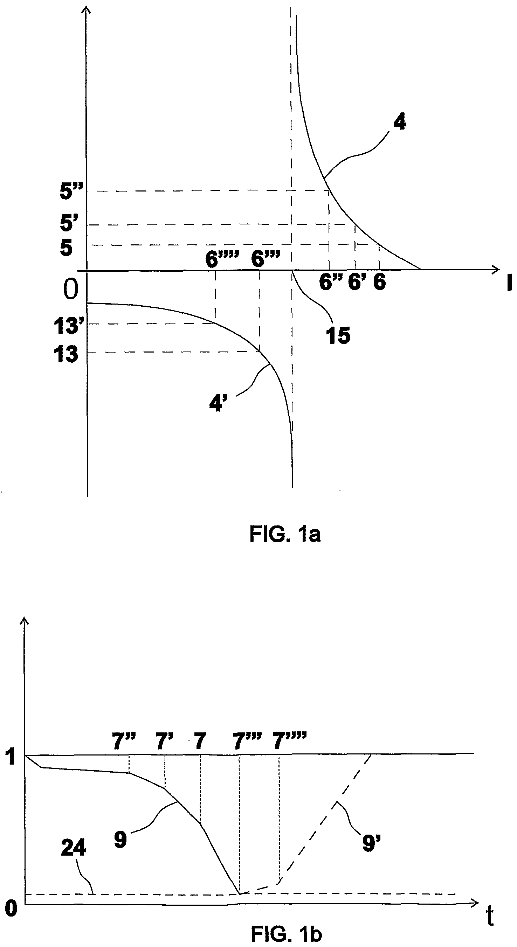

Fig. 1 a shows a representation 4, 4' according to the invention which is used for the estimation of instantaneous load capacity of a fuse 2. The fuse time to failure 5, 5', 5" and correspondingly the fuse recovery time 13, 13' are represented with respect to the current I 6, 6', 6", 6"', 6"" flowing through the fuse. Here the representation has been made for a so-called slow fuse, which is the type of fuse used for the interruption of overcurrent e.g. in the electricity connection of a building, but a corresponding representation 4 of time to failure 5, 5', 5" and/or a representation 4' of fuse recovery time 13, 13' can also be made for other power supply circuit fuses for which the time elapsing until fuse failure and/or recovery can be determined e.g. experimentally or on the basis of the material and/or thermal time constant of the fuse with respect to the electric quantity constituting a load on the fuse.

From characteristic 4 in Fig. 1 a it can be seen that the time-to-failure 5, 5', 5" of the fuse 2 is reduced as the fuse current I 6, 6', 6" increases. This is due to the fact that the resistive thermal losses of the fuse increase as a function of its load current, leading to accelerated warming-up of the fuse. When the fuse current is reduced, the time to failure again begins to increase correspondingly, and when the current falls below a given boundary value 15, the fuse finally begins to recover. The recovery time 13,13' is represented in Fig. 1 a by a characteristic 4' similar to that for the time-to-failure 5, 5', 5". Here the recovery time is defined by negative values, whereas the time to failure is defined by values of positive sign. The recovery time is the shorter the smaller is the current load 6"', 6"" on the fuse, because the fuse will then cool down faster.

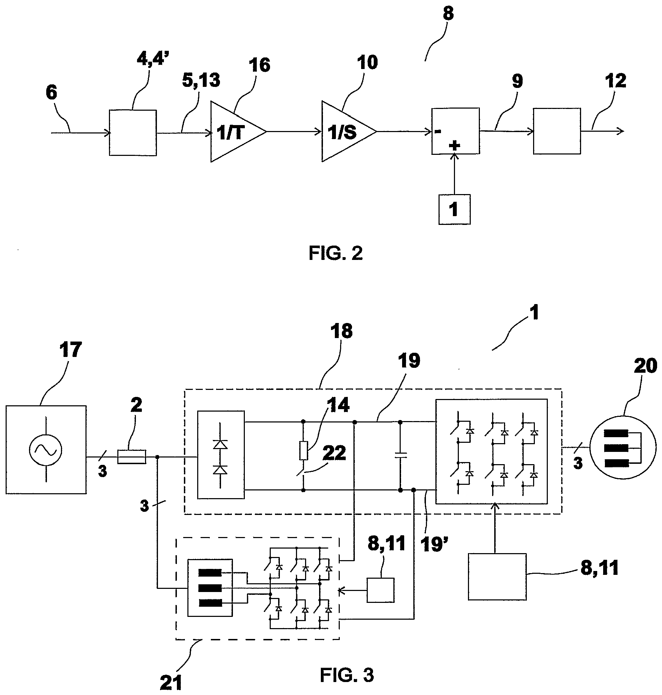

Fig. 1b represents the instantaneous load capacity 9, 9' of a slow fuse as a function of time t when the load capacity 9, 9' is estimated in the manner presented in the block diagram in Fig. 2. The instantaneous value 6, 6', 6", 6"', 6"" of the current flowing through the fuse is measured, and the measured current is low-pass filtered. The time-to-failure 5, 5', 5" of the fuse corresponding to the instantaneous value of the low-pass filtered current is determined from characteristic 4, and the recovery time 13, 13' of the fuse is determined from characteristic 4'. For the fuse time-to-failure 5, 5', 5" and fuse recovery time 13, 13' thus determined, an inverse value 16 is calculated repeatedly, and the calculated inverse value is integrated 10. In this embodiment of the invention, the integration is performed by summing the latest calculated value at one-second intervals to the integral value. The instantaneous load capacity of the fuse is determined as a relative value, so that value 1 corresponds to the highest instantaneous load capacity allowed for the fuse 2. The instantaneous load capacity 9 of the fuse is obtained by subtracting the calculated integral 10 of the inverse value from the standard value 1. The inverse values of the time-to-failure 5, 5', 5" that are included in the integration reduce the instantaneous load capacity 9, 9'; on the other hand, the inverse values of the fuse recovery time 13, 13' again correspondingly increase the instantaneous load capacity 9, 9' in conjunction with integration, because these inverse values of the recovery time are of negative sign.

The characteristic 4' for the fuse recovery time 13, 13' can also be replaced by a given standard value of recovery time, in which case the duration of recovery of the fuse is not determined quite as accurately but the calculation of instantaneous load capacity is simplified. In this case, using a safety margin, a recovery time is selected that is long enough to ensure that recovery from overloading has taken place before the instantaneous load capacity of the fuse is restored to value 1.

In Fig. 1b, at instant t=0 the instantaneous load capacity 9 of the fuse is at a maximum, having the value of 1. After this, the current flowing through the fuse increases over the limit value 15, and at instant 7" indicated in Fig. 1b the fuse current is determined to have value 6". For the time-to-failure corresponding to this current value 6", value 5" is determined from characteristic 4 in Fig. 1 a. At instant 7', the fuse current has value 6', and at instant 7 value 6, correspondingly. The time-to-failure 5, 5', 5" corresponding to each current value 6, 6', 6" is defined, and an inverse value is computed for the time-to-failure defined. The inverse value is integrated with respect to time and, based on the integral, the instantaneous load capacity 9 of the fuse is defined according to the block diagram in Fig. 2. From Fig. 1b it can be seen that, as the fuse current increases, the instantaneous load capacity 9 begins to fall faster. If the fuse is further operated under a large current load, the instantaneous load capacity 9 would finally fall to zero, in which case the fuse might be blown. For this reason, the current flowing through the fuse should be restricted before the instantaneous load capacity falls to zero, by using a safety margin 24 as indicated in Fig. 1b. The fuse current is thus restricted to a value below the limit current value 15 indicated in Fig. 1a. As the current becomes restricted, the fuse begins to recover and its instantaneous load capacity begins to rise. This increase in instantaneous load capacity is indicated by the broken line 9' in Fig. 1 b. At instant 7"', the fuse current reaches value 6"', and the corresponding recovery time 13 is determined from characteristic 4'. At instant 7"", the fuse current has been further reduced, and the required recovery time 13' is therefore also shorter. As the fuse current is further reduced and the recovery time becomes shorter, the instantaneous load capacity 9' of the fuse computed according to the block diagram in Fig. 2 also begins to increase faster.

Fig. 3 represents a transportation system power supply arrangement with an arrangement according to the invention fitted in it for protecting a fuse 2 in the power supply 17. The power supply circuit 1 of the transportation system includes a controllable frequency converter 18, which has been adapted to supply power from an electricity network 17 to the motor 20 driving the transport apparatus under control of the frequency converter. Connected to the intermediate circuit of the frequency converter is a controllable three-phase mains inverter 21, which has been adapted to feed power returning from the motor 20 during motor braking further into the phases of the electricity network 17 under control of the power inverter. Fitted in each one of the three phases of the power supply 17 is a fuse 2 to be protected.

The arrangement comprises estimation of the load capacity of the fuse 2. The instantaneous load capacity 9, 9' of the fuse is estimated e.g. in the manner described in the embodiment examples represented by Figs. 1a, 1b and 2. The load current of each of the three power supply phases is determined indirectly on the basis of measurement of the intermediate circuit current of the frequency converter, and therefore a separate measurement of the fuse current in not necessarily needed. The current flowing through each fuse 2 of the power supply is adapted to be limited to a certain limit current value 12, and this limit current value is determined on the basis of the estimated load capacity 9, 9' of the fuse 2. When the instantaneous load capacity 9, 9' of the fuse is reduced to a level close to zero, the fuse current is limited to a value below the limit current value 15 shown in Fig. 1a, whereupon the fuse 2 begins to recover from overloading. The aforesaid limit current value 15 may be e.g. equal to the nominal current of the fuse.

Connected to the intermediate circuit of the frequency converter 18, between the positive 19 and negative 19' intermediate circuit rails, is a series circuit of a power resistor 14 and a controllable switch 22. Power exceeding the limited current handling capacity of the fuse 2 during motor braking of the electric motor 20 has been adapted to be consumed in the aforesaid power resistor 14.

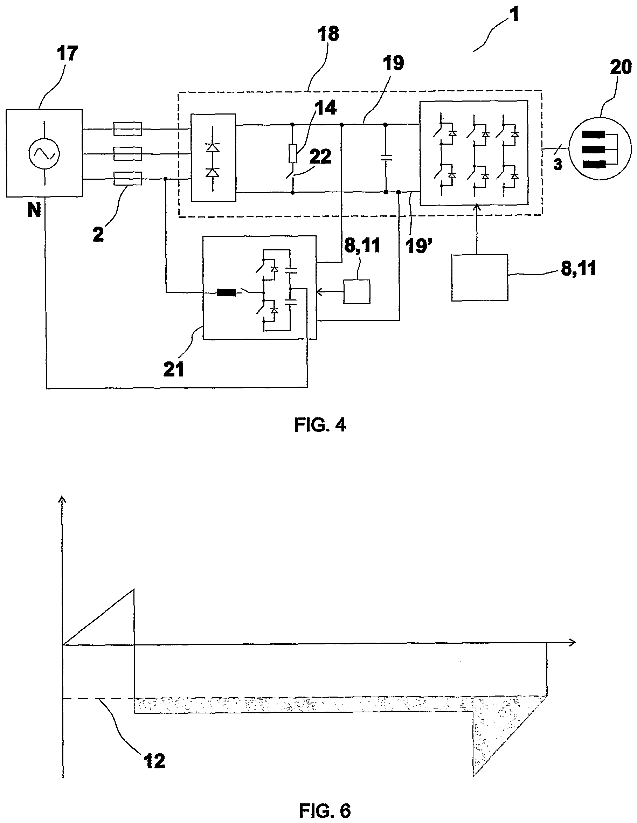

The transportation system power supply arrangement presented in Fig. 4 differs from the arrangement presented in Fig. 3 in that here the controllable 11 mains inverter 21 fitted between the intermediate circuit of the frequency converter 18 and the electricity network 17 is a single-phase device. In this case, the mains inverter is connected to only one of the three phases of the electricity network. During motor braking of the motor 20 driving the transportation apparatus, the power returning to the frequency converter is thus transferred via the mains inverter 21 to that electricity network phase to which the mains inverter 21 is connected. Since the mains inverter current also flows through the corresponding electricity network fuse 2, the fuse in this phase is subjected to the highest current load. When the said fuse is to be protected e.g. by determining the instantaneous load capacity of the fuse in the manner described in the embodiment examples of Figs. 1a, 1b and 2, the current to be sustained by the fuse 2 being protected can be restricted to a certain limit current value e.g. by using an arrangement such that, when the instantaneous load capacity 9, 9' of the fuse is reduced close to zero, the fuse current is limited to a value below the nominal current of the fuse. In this way, the aforesaid fuse 2 can be momentarily subjected to a current load exceeding the nominal current. The power supply range of the single-phase mains inverter 21 can thus be substantially extended, and it is consequently possible in many applications to replace a three-phase mains inverter with a single-phase solution.

Fig. 5 represents an elevator system in which the supply of power to the elevator motor 20 is adjusted by means of a frequency converter 18. When the force exerted by the elevator motor 20 is acting against the direction of motion of the elevator car 23, power returns from the elevator motor 20 to the frequency converter 18. From the intermediate circuit of the frequency converter, the power is transferred by a single-phase mains inverter 21 further to the electricity network 17. Thus, the power supply arrangement draws power from the electricity network 17 in a three-phase manner, whereas the power produced during motor braking is returned to only one of the phases of the electricity network, which is why the said phase receiving the returned power is subjected to a greater load than the other phases.

The power returned to the electricity network 17 also flows through the power supply fuse 2, and consequently the fuse in the electricity network phase connected to the mains inverter 21 is subjected to a greater load than the fuses in the other phases. For this reason, the elevator system is provided with an arrangement according to the invention for protecting a power supply fuse. The instantaneous load capacity of the fuse in the aforesaid electricity network 17 phase connected to the mains inverter 21 is determined e.g. in the manner described in the embodiment examples of Figs. 1a, 1b and 2. The current supplied by the mains inverter 21 into the electricity network 17 is limited to a limit value 12 defined on the basis of the estimated load capacity 9, 9' of the said fuse 2. In this way, an overload exceeding the nominal current of the fuse can be momentarily fed through the fuse being protected, and the power supply can be implemented using a single-phase mains inverter 21 instead of a three-phase device. Fitted in conjunction with the main current circuit of the frequency converter 18 is also a power resistor 14, and the power supplied through this resistor is controlled by means of a separate switch. If the instantaneous power returning from the electric motor 20 to the frequency converter 18 exceeds the power handling capacity of the power supply fuse 2, then the extra braking power is converted into heat in the power resistor 14.

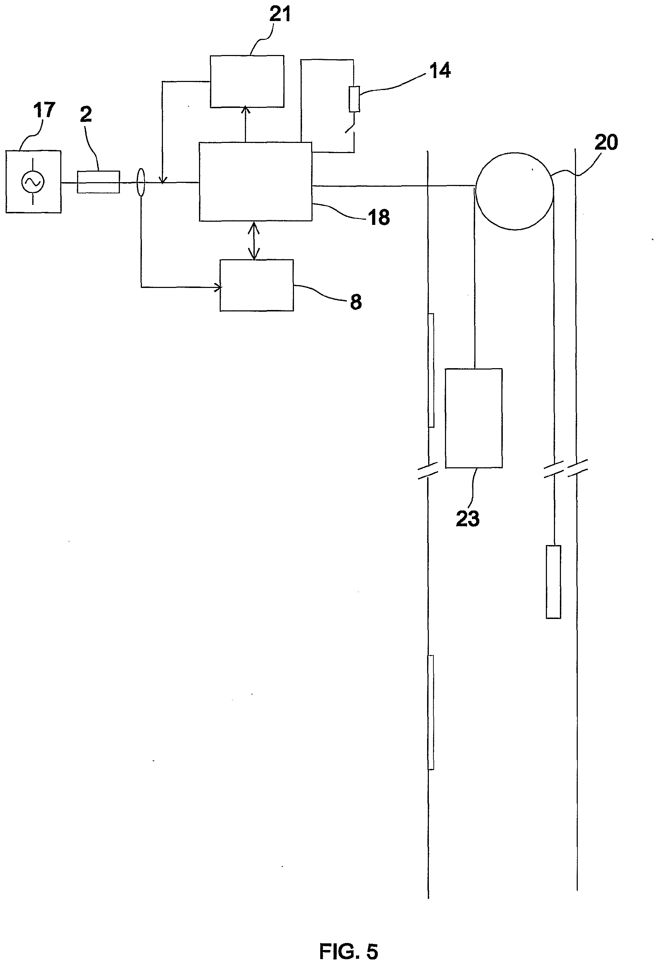

Fig. 6 visualizes power flow in an elevator system according to Fig. 5 during an elevator run. In this example, the elevator travels in the light direction, so the direction of motion of the elevator car is opposite to the force exerted by the elevator motor and, except for the initial acceleration, the elevator motor operates in the motor braking mode. In this situation, the mains inverter 21 feeds power from the frequency converter's intermediate circuit into the electricity network 17. The figure also shows the afore-mentioned limit value 12 set for the current flowing through the electricity supply fuse 2. The shaded area exceeding the current limit represents the braking power dissipated in the power resistor 14 during motor braking.

In an embodiment of the invention, the motion of the transportation apparatus 23, such as the velocity, acceleration and/or deceleration of the elevator car, is limited in accordance with the estimated load capacity 9, 9' of the electricity supply fuse 2.

The invention is not exclusively limited to the above-described embodiment examples, but many variations are possible within the scope of the inventive concept defined in the claims.

The fuse failure time and/or recovery time may be affected e.g. by ambient temperature and possible cooling of the fuse.

The motor driving the transportation apparatus may be a rotary motor or also a linear motor, in which case the movable rotor may be attached directly to the transportation apparatus.

Some of the power returning to the frequency converter during motor braking may also be utilized for satisfying the power requirement of the electrification of the transportation system.

The magnitude of the power flow from the motor driving the transportation apparatus into the frequency converter's intermediate circuit can also be determined e.g. on the basis of measurements of motor current and/or voltage.

## Claims

1. An arrangement for protecting a fuse (2) in a power supply circuit (1);
said arrangement comprising determination of an electric quantity constituting a load on the fuse (2);
which electric quantity (6, 6', 6") constituting a load on the fuse is determined repeatedly while the fuse is exposed to the load;
and said arrangement comprising estimation (8) of instantaneous load capacity of the fuse (2); **characterized in that**
the estimation of instantaneous load capacity (9, 9') is performed using limitation criteria (5, 5', 5", 13, 13') set for the load capacity of the fuse; a first limitation criterion (5, 5', 5") indicates the longest possible operating time of the fuse (2) under a given loading condition;
and for the limitation criterion (5, 5', 5"), a representation (4, 4') with respect to the electric quantity (6, 6', 6") constituting a load on the fuse is provided;
and a limitation criterion corresponding to the defined electric quantity (6, 6', 6") constituting a load on the fuse is derived repeatedly from the said representation (4, 4') while the fuse (2) is exposed to the load;
the estimate of instantaneous load capacity (9, 9') of the fuse is thus determined on the basis of both the limitation criterion (5) defined substantially at the estimation instant (7) and the limitation criteria (5', 5") defined before this, and
the estimation of instantaneous load capacity (9, 9') is performed using additionally a second limitation criterion (13, 13') set for the load capacity of the fuse,
this second limitation criterion (13, 13') indicating the recovery time of the fuse (2) under a given loading condition.

2. An arrangement according to claim 1,
**characterized in that**
the arrangement comprises a representation (4) of the time to failure (5, 5', 5") of the fuse, wherein the time to failure is represented with respect to an electric quantity (6, 6', 6") constituting a load on the fuse;
and that the said electric quantity (6, 6', 6") constituting a load on the fuse and the corresponding time to failure (5, 5', 5") are defined repeatedly;
and that the estimate of instantaneous load capacity (9, 9') of the fuse (2) is determined on the basis of both the time to failure (5) defined substantially at the moment of estimation and the times to failure (5' 5") defined previously.

3. An arrangement according to any one of the preceding claims, **characterized in that** an inverse value is calculated for the fuse time-to-failure (5, 5', 5") corresponding to the defined value of the electric quantity;
and that the said inverse value is integrated (10) with respect to time;
and that the said integral (10) of the inverse value is used in the estimation of instantaneous load capacity (9, 9') of the fuse.

4. An arrangement according to any one of the preceding claims, **characterized in that** the power supply circuit (1) comprises a control function (11);
which power supply control function is adapted to limit the current flowing through a fuse in the power supply circuit to a given boundary current value (12);
said boundary current value being determined according to an estimated instantaneous load capacity (9) of the fuse.

5. An arrangement according to claim 4, **characterized in that** the power supply control function (11) is adapted to limit the current flowing through the fuse (2) in the power supply circuit (1) to a given non-zero boundary current value (12) if the instantaneous load capacity (9, 9') of the fuse deviates from an allowed range.

6. An Apparatus arrangement according to any one of the preceding claims, **characterized in that** the aforesaid power supply circuit fuse (2) is a fuse in the power supply to a building.

7. An arrangement according to any one of the preceding claims, **characterized in that** the arrangement comprises a representation (4') of fuse recovery time (13, 13'), wherein the recovery time is represented with respect to the electric quantity (6"', 6"") constituting a load on the fuse;
and than the said electric quantity (6"', 6"") constituting a load on the fuse as well as the corresponding fuse recovery time (13, 13') are determined repeatedly;
and that the instantaneous estimate of the load capacity of the fuse (2) is determined on the basis of both the fuse recovery time (13') defined substantially at the instant of estimation (7"") and the recovery times (13) defined before this.

8. An arrangement according to claim 7, **characterized in that** an inverse value is calculated for the fuse recovery time (13, 13') corresponding to the defined value of the electric quantity;
and that the said inverse value is integrated (10) with respect to time;
and that the estimation of instantaneous load capacity (9, 9') of the fuse is performed using the integral (10) of the inverse value.

9. A transportation system, which comprises a power supply circuit (1) of the transportation system;
and said system comprising an arrangement for protecting a fuse (2) in the power supply to the transportation system according to one of the preceding claims.

10. A transportation system according to claim 9, **characterized in that** power exceeding the limited current handling capacity of the fuse is adapted to be consumed in a resistor (14) connected to the power supply circuit (1) of the transportation system.

11. A transportation system according to claim 9 or 10, **characterized in that** movement of the transportation apparatus (23) is limited according to the estimated load capacity (9, 9') of the fuse (2).

12. An elevator system, **characterized in that** the elevator system comprises an arrangement according to any one of claims 1 - 8 for protecting a fuse (2) in the power supply circuit (1) of the elevator system.

13. An elevator system according to claim 12, **characterized in that** data indicating the instantaneous load capacity (9, 9') of the fuse (2) in the power supply circuit (1) of the elevator system is arranged to be transmitted to an elevator maintenance center.

## Patentansprüche

1. Anordnung zum Schützen einer Sicherung (2) in einer Stromversorgungsschaltung (1); welche Anordnung eine Bestimmung einer elektrischen Größe beinhaltet, die eine Last der Sicherung (2) darstellt;
welche eine Last der Sicherung darstellende elektrische Größe (6, 6', 6") wiederholt bestimmt wird, während die Sicherung der Last ausgesetzt ist; und
die Anordnung enthält eine Abschätzung (8) der spontanen Lastkapazität der Sicherung (2); **dadurch gekennzeichnet, dass** die Abschätzung der spontanen Lastkapazität (9, 9') durchgeführt wird unter Verwendung eines Begrenzungskriteriums (5, 5', 5", 13, 13'), welches für die Lastkapazität der Sicherung gesetzt wird;
wobei ein erstes Begrenzungskriterium (5, 5', 5") die längstmögliche Betriebszeit der Sicherung (2) unter einer gegebenen Lastsituation indiziert;
und für das Begrenzungskriterium (5, 5', 5") wird eine Repräsentation (4, 4') mit Bezug auf die elektrische Größe (6, 6', 6") bereitgestellt, die eine Last auf die Sicherung darstellt;
und ein Begrenzungskriterium entsprechend der eine Last auf die Sicherung darstellenden definierten elektrischen Größe (6, 6', 6") wird wiederholt erhalten von der Repräsentation (4, 4'), während die Sicherung (2) der Last ausgesetzt ist;
die Abschätzung der spontanen Lastkapazität (9, 9') der Sicherung wird so bestimmt auf der Basis sowohl des Begrenzungskriteriums (5), welches im Wesentlichen zum Zeitpunkt (7) der Abschätzung definiert wird und des Begrenzungskriteriums (5, 5"), welches vorher definiert wurde, und
die Abschätzung der spontanen Lastkapazität (9, 9') wird durchgeführt unter Verwendung eines zusätzlichen zweiten Begrenzungskriteriums (13, 13'), welches für die Lastkapazität der Sicherung gesetzt wird, wobei dieses zweite Begrenzungskriterium (13, 13') die Erholungszeit der Sicherung (2) unter einer gegebenen Lastsituation indiziert.

2. Anordnung nach Anspruch 1, **dadurch gekennzeichnet, dass** die Anordnung eine Repräsentation (4) der Zeit bis zum Fehler (5, 5', 5 ") der Sicherung aufweist, wobei die Zeit bis zum Fehler repräsentiert wird mit Bezug auf eine eine Last auf die Sicherung darstellende elektrische Größe (6, 6', 6");
und die eine Last auf die Sicherung darstellende elektrische Größe (6, 6', 6") und die entsprechende Zeit bis zum Fehler (5, 5', 5") werden wiederholt definiert;
und die Abschätzung der spontanen Lastkapazität (9, 9') der Sicherung (2) wird bestimmt auf der Basis sowohl der Zeit bis zum Fehler (5), die im Wesentlichen zum Moment der Abschätzung definiert wird, und der Zeit bis zum Fehler (5', 5"), die vorher definiert wurde.

3. Anordnung nach einem der vorhergehenden Ansprüche, **dadurch gekennzeichnet, dass** ein inverser Wert kalkuliert wird für die Zeit bis zum Fehler (5, 5', 5") der Sicherung entsprechend dem definierten Wert der elektrischen Größe;
und dass der inverse Wert integriert (10) wird über die Zeit;
und dass das Integral (10) des inversen Wertes verwendet wird bei der Abschätzung der spontanen Lastkapazität (9, 9') der Sicherung.

4. Anordnung nach einem der vorhergehenden Ansprüche, **dadurch gekennzeichnet, dass** die Stromzufuhrschaltung (1) eine Steuerfunktion (11) enthält;
welche Stromzufuhrsteuerfunktion geeignet ist, den Strom, der durch eine Sicherung in der Stromzufuhrschaltung fließt, auf einen gegebenen Stromgrenzwert (12) zu beschränken;
welcher Stromgrenzwert bestimmt wird entsprechend einer geschätzten spontanen Lastkapazität (9) der Sicherung.

5. Anordnung nach Anspruch 4, **dadurch gekennzeichnet, dass** die Stromversorgungssteuerfunktion (11) geeignet ist, den durch die Sicherung (2) in der Stromzufuhrschaltung (1) fließenden Strom auf einen gegebenen Grenzstromwert (12) zu begrenzen, der nicht Null ist, wenn die spontane Lastkapazität (9, 9') der Sicherung von einem erlaubten Bereich abweicht.

6. Anordnung nach einem der vorhergehenden Ansprüche, **dadurch gekennzeichnet, dass** die vorgenannte Stromversorgungsschaltungssicherung (2) eine Sicherung in der Stromzufuhr eines Gebäudes ist.

7. Anordnung nach einem der vorhergehenden Ansprüche, **dadurch gekennzeichnet, dass** die Anordnung eine Repräsentation (4') der Erholungszeit der Sicherung (13, 13') enthält, wobei die Erholungszeit repräsentiert wird mit Bezug auf die eine Last der Sicherung darstellende elektrische Größe (6"', 6"");
und dass die eine Last der Sicherung darstellende elektrische Größe (6"', 6"") als auch die entsprechende Erholungszeit (13, 13') der Sicherung wiederholt bestimmt werden;
und dass die spontane Abschätzung der Lastkapazität der Sicherung (2) durchgeführt wird sowohl auf der Erholungszeit (13') der Sicherung, die im Wesentlichen zum Zeitpunkt der Abschätzung definiert wird, als auch der Erholungszeit (13), die davor definiert wurde.

8. Anordnung nach Anspruch 7, **dadurch gekennzeichnet, dass** ein inverser Wert für die Erholungszeit (13, 13') der Sicherung errechnet wird entsprechend dem definierten Wert der elektrischen Größe;
und dass der inverse Wert integriert wird über die Zeit;
und dass die Abschätzung der spontanen Lastkapazität (9, 9') der Sicherung durchgeführt wird unter Verwendung des Integrals (10) des inversen Wertes.

9. Transportsystem, welches eine Stromversorgungsschaltung (1) des Transportsystems aufweist,
und dass das System eine Anordnung zum Schützen einer Sicherung (2) in der Stromversorgung des Transportsystems entsprechend einem der vorhergehenden Ansprüche aufweist.

10. Transportsystem nach Anspruch 9, **dadurch gekennzeichnet, dass** ein Strom, der die begrenzte Stromhandhabungskapazität der Sicherung überschreitet, geeignet ist, um in einem Widerstand, der mit der Stromversorgungsschaltung (1) des Transportsystems verbunden ist, aufgebraucht zu werden.

11. Transportsystem nach Anspruch 9 oder 10, **dadurch gekennzeichnet, dass** die Bewegung des Transportapparates (23) begrenzt wird entsprechend der geschätzten Lastkapazität (9, 9') der Sicherung (2).

12. Aufzugsystem, **dadurch gekennzeichnet, dass** das Aufzugsystem eine Anordnung nach einem der Ansprüche 1 bis 8 zum Schützen einer Sicherung (2) in der Stromversorgungsschaltung (1) des Aufzugsystems aufweist.

13. Aufzugsystem nach Anspruch 12, **dadurch gekennzeichnet, dass** Daten, welche die spontane Lastkapazität (9, 9') der Sicherung (2) in der Stromversorgungsschaltung (1) des Aufzugsystems indizieren, bestimmt sind, um zu einem Aufzugwartungszentrum übermittelt zu werden.

## Revendications

1. Agencement pour protéger un fusible (2) dans un circuit d'alimentation électrique (1) ;
ledit agencement comprenant la détermination d'une quantité électrique constituant une charge sur le fusible (2) ;
ladite quantité électrique (6, 6', 6") constituant une charge sur le fusible étant déterminée de manière répétée tandis que le fusible est exposé à la charge ;
et ledit agencement comprenant l'estimation (8) de la capacité de charge instantanée du fusible (2) ; **caractérisé en ce que**
l'estimation de la capacité de charge instantanée (9, 9') est réalisée en utilisant des critères de limitation (5, 5', 5", 13, 13') définis pour la capacité de charge du fusible ;
un premier critère de limitation (5, 5', 5") indique le temps de fonctionnement le plus long possible du fusible (2) sous une condition de chargement donnée ;
et, pour le critère de limitation (5, 5', 5"), une représentation (4, 4') par rapport à la quantité électrique (6, 6', 6") constituant une charge sur le fusible est fournie ;
et un critère de limitation correspondant à la quantité électrique définie (6, 6', 6") constituant une charge sur le fusible est dérivé de manière répétée de ladite représentation (4, 4') tandis que le fusible (2) est exposé à la charge ;
l'estimation de la capacité de charge instantanée (9, 9') du fusible est ainsi déterminée sur la base à la fois du critère de limitation (5) défini sensiblement au moment de l'estimation (7) et des critères de limitation (5', 5") définis avant cela, et l'estimation de la capacité de charge instantanée (9, 9') est réalisée en utilisant de plus un second critère de limitation (13, 13') défini pour la capacité de charge du fusible,
ce second critère de limitation (13, 13') indiquant le temps de récupération du fusible (2) sous une condition de chargement donnée.

2. Agencement selon la revendication 1, **caractérisé en ce que** l'agencement comprend une représentation (4) du temps de fonctionnement avant panne (5, 5', 5") du fusible, dans lequel le temps de fonctionnement avant panne est représenté par rapport à une quantité électrique (6, 6', 6") constituant une charge sur le fusible ;
et **en ce que** ladite quantité électrique (6, 6', 6") constituant une charge sur le fusible et le temps de fonctionnement avant panne correspondant (5, 5', 5") sont définis de manière répétée ;
et **en ce que** l'estimation de la capacité de charge instantanée (9, 9') du fusible (2) est déterminée sur la base à la fois du temps de fonctionnement avant panne (5) défini sensiblement au moment de l'estimation et des temps de fonctionnement avant panne (5', 5") définis précédemment.

3. Agencement selon une quelconque des revendications précédentes, **caractérisé en ce qu'**une valeur inversée est calculée pour le temps de fonctionnement avant panne (5, 5', 5") du fusible qui correspond à la valeur définie de la quantité électrique ;
et **en ce que** ladite valeur inversée est intégrée (10) par rapport au temps ;
et **en ce que** ladite intégrale (10) de la valeur inversée est utilisée dans l'estimation de la capacité de charge instantanée (9, 9') du fusible.

4. Agencement selon une quelconque des revendications précédentes, **caractérisé en ce que** le circuit d'alimentation électrique (1) comprend une fonction de commande (11) ;
ladite fonction de commande d'alimentation électrique étant adaptée pour limiter la circulation du courant à travers un fusible dans le circuit d'alimentation électrique sur une valeur de courant limite donnée (12) ;
ladite valeur de courant limite étant déterminée selon une capacité de charge instantanée estimée (9) du fusible.

5. Agencement selon la revendication 4, **caractérisé en ce que** la fonction de commande d'alimentation électrique (11) est adaptée pour limiter la circulation du courant à travers le fusible (2) dans le circuit d'alimentation électrique (1) sur une valeur de courant limite donnée (12) non égale à zéro si la capacité de charge instantanée (9, 9') du fusible dévie d'une plage autorisée.

6. Agencement de dispositif selon une quelconque des revendications précédentes, **caractérisé en ce que** ledit fusible de circuit d'alimentation électrique (2) est un fusible dans l'alimentation électrique vers un bâtiment.

7. Agencement selon une quelconque des revendications précédentes, **caractérisé en ce que** l'agencement comprend une représentation (4') de temps de récupération de fusible (13, 13'), dans lequel le temps de récupération est représenté par rapport à la quantité électrique (6"', 6"") constituant une charge sur le fusible ;
et **en ce que** ladite quantité électrique (6"', 6"") constituant une charge sur le fusible ainsi que le temps de récupération de fusible correspondant (13, 13') sont déterminés de manière répétée ;
et **en ce que** l'estimation instantanée de la capacité de charge du fusible (2) est déterminée sur la base à la fois du temps de récupération de fusible (13') défini sensiblement au moment de l'estimation (7"") et des temps de récupération (13) définis avant celui-ci.

8. Agencement selon la revendication 7, **caractérisé en ce qu'**une valeur inversée est calculée pour le temps de récupération (13, 13') du fusible qui correspond à la valeur définie de la quantité électrique ;
et **en ce que** ladite valeur inversée est intégrée (10) par rapport au temps ;
et **en ce que** l'estimation de la capacité de charge instantanée (9, 9') du fusible est réalisée en utilisant l'intégrale (10) de la valeur inversée.

9. Système de transport, qui comprend un circuit d'alimentation électrique (1) du système de transport ;
et ledit système comprenant un agencement pour protéger un fusible (2) dans l'alimentation électrique vers le système de transport selon une des revendications précédentes.

10. Système de transport selon la revendication 9, **caractérisé en ce que** la puissance dépassant la capacité de gestion de courant limitée du fusible est adaptée pour être consommée dans une résistance (14) reliée au circuit d'alimentation électrique (1) du système de transport.

11. Système de transport selon la revendication 9 ou 10, **caractérisé en ce que** le mouvement de l'appareil de transport (23) est limité selon la capacité de charge (9, 9') estimée du fusible (2).

12. Système d'ascenseur, **caractérisé en ce que** le système d'ascenseur comprend un agencement selon une quelconque des revendications 1 à 8 pour protéger un fusible (2) dans le circuit d'alimentation électrique (1) du système d'ascenseur.

13. Système d'ascenseur selon la revendication 12, **caractérisé en ce que** les données indiquant la capacité de charge instantanée (9, 9') du fusible (2) dans le circuit d'alimentation électrique (1) du système d'ascenseur sont agencées pour être transmises à un centre de maintenance d'ascenseur.
